# FASCICULE DE BREVET EUROPEEN

(11) **EP 3 035 125 B1**
(45) Date de publication et mention de la délivrance du brevet: **10.01.2018**
(21) Numéro de dépôt: 14199213.1
(22) Date de dépôt: 19.12.2014
(51) Int. Cl.: G04B 11/04, G04B 13/02, G04B 15/14, B81C 99/00

(54) **Procédé de fabrication d'un composant horloger multi-niveaux**
Herstellungsverfahren einer mehrstufigen Uhrenkomponente
Method for manufacturing a multi-level clock component

(43) Date de publication de la demande: 22.06.2016
(73) Titulaire: ROLEX SA, 1211 Genève 26 (CH)
(72) Inventeur: Calame, Florian, CH-1066 Epalinges (CH)
(74) Mandataire: Moinas & Savoye SARL

(56) Documents cités:
- EP-A1- 2 060 534
- CH-A2- 701 266

## Description

La présente invention concerne un procédé de fabrication d'un composant métallique par une technique de photolithographie et dépôt galvanique. Ce type de procédé est utilisé notamment pour la fabrication de composants métalliques se présentant sous la forme de microstructures tridimensionnelles à plusieurs niveaux, pour former notamment des composants de mouvement horloger.

DGC Mitteilungen No. 104, 2005, mentionne l'utilisation de la technologie LIGA (Lithographie Galvanik Abformung : méthode conçue par W. Ehrfeld du Karlsruhe Nuclear Research Center, Allemagne) pour la fabrication de pièces métalliques horlogères de haute précision, telles que par exemple des ancres ou des roues d'échappement. Ce procédé comprend la formation d'un moule en résine sensible aux rayons X, par irradiation avec un faisceau de rayons X de haute énergie généré par un synchrotron, ce qui représente un inconvénient majeur.

A.B. Frazier et al., Journal of Microelectromechanical systems, 2, 2, June 1993, décrit la fabrication de structures métalliques par électrodéposition de métal dans des moules en résine photosensible (photorésist) à base de polyimide, préparés à l'aide d'un procédé utilisant une technologie appelée LIGA-UV, analogue à la technologie LIGA mentionnée ci-dessus mais avec une illumination UV de la résine à la place de l'irradiation aux rayons X.

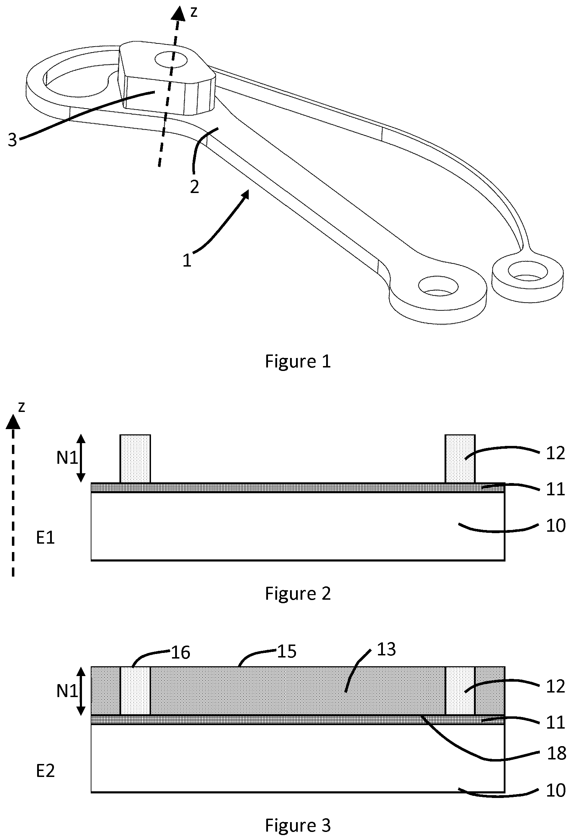

Les formes tridimensionnelles des composants horlogers sont souvent complexes, et comprennent des discontinuités formées par des portions superposées de sections très différentes. A titre d'exemple, la figure 1 représente un sautoir 1, comprenant une portion inférieure 2 de surface supérieure plane sur laquelle s'étend une seconde portion 3. Une telle forme tridimensionnelle est appelée « forme à plusieurs niveaux », car il est possible de distinguer deux portions 2, 3 superposées de sections très différentes dans une certaine direction z, formant une discontinuité au niveau de leur frontière, dans le plan de la surface supérieure de la portion inférieure 2. Chaque portion 2, 3 comprend une section par un plan perpendiculaire à la direction z sensiblement constante ou variant continument. Si les portions d'un composant présentant une forme à plusieurs niveaux sont réalisées par des couches distinctes de dépôt galvanique lors de la mise en oeuvre d'un procédé LIGA, on constate une faiblesse du composant résultant au niveau de la frontière entre ces couches distinctes, qui peut conduire à une séparation accidentelle des couches. Il convient donc de définir un procédé de fabrication d'un composant horloger à plusieurs niveaux qui lui permet de supporter des contraintes mécaniques importantes, notamment de cisaillement et/ou de traction en direction verticale.

Le brevet EP2405300 décrit différents exemples de réalisation d'un procédé de fabrication d'une pièce métallique à au moins deux niveaux. Selon un exemple particulier de réalisation, le procédé comprend les étapes successives suivantes :
- déposer une première couche de résine photosensible sur un substrat recouvert d'une couche conductrice, cette première couche définissant un premier niveau ;
- obtenir un premier moule en réalisant une cavité dans la première couche de résine par photolithographie à l'aide d'un masque, suivie d'un développement de la résine ;
- déposer un métal ou un alliage dans le premier moule, par un dépôt galvanique amorcé par la couche conductrice, afin de former une couche métallique de premier niveau ;
- enlever complètement la résine restante de la première couche pour ne laisser sur le substrat que la couche métallique de premier niveau ;
- déposer une deuxième couche de résine sur le substrat, par exemple d'épaisseur plus importante que la couche métallique de premier niveau, puis, par photolithographie à l'aide d'un masque suivie d'un développement de la résine, former un espace creux délimité par la couche conductrice, les flancs de la couche métallique de premier niveau et des flancs de la deuxième couche de résine.

Cet espace creux constitue en définitive un deuxième moule dans lequel on peut déposer un métal ou alliage par un dépôt galvanique amorcé par la couche conductrice et former (après retrait de la résine et du substrat) un composant métallique ayant au moins deux niveaux imbriqués l'un dans l'autre.

En résumé, le document EP2405300 propose donc la fabrication d'un composant à plusieurs niveaux à l'aide de couches distinctes obtenues par un procédé LIGA, de sorte que ces couches distinctes soient imbriquées, ce qui leur permet de garantir une bonne liaison entre elles, réduisant ainsi le risque de leur séparation accidentelle. Toutefois, ce procédé est consommateur en temps de fabrication et complexifie les moules en résine à fabriquer pour la formation de chaque couche.

Le document EP0851295 décrit une autre approche reposant sur la réalisation d'une microstructure en résine photosensible avec des dépôts et insolations successives de résine, mais un développement de la résine insolée en une seule fois, pour obtenir un moule tridimensionnel complexe correspondant au composant à fabriquer. Ensuite, le composant est obtenu par un dépôt électrolytique au sein de ce moule. L'avantage de cette approche est d'obtenir un ensemble métallique monolithique, les différents niveaux étant réalisés lors d'une même étape, donc pouvant être assimilés à une seule couche. Il en résulte une meilleure résistance mécanique des portions des différents niveaux puisqu'il n'y a plus la faiblesse constatée par la frontière entre des couches distinctes. Son inconvénient est sa complexité, notamment pour former le moule en résine. Cette approche ne permet pas non plus d'obtenir toutes les formes souhaitées. Le document EP 2 060 534 A1 décrit également une méthode de réalisation d'une microstructure comprenant une étape de fabrication d'une première couche métallique d'un composant horloger sur la surface supérieure d'un substrat. Ainsi, la présente invention a pour objet d'améliorer la situation et de proposer une solution améliorée de fabrication d'un composant métallique tridimensionnel. Notamment, cette solution peut lui permettre d'atteindre une résistance mécanique satisfaisante, notamment lorsqu'il se présente selon une forme à au moins deux niveaux. Cette solution facilite aussi la réalisation de certaines géométries de composants à plusieurs niveaux.

A cet effet, l'invention concerne un procédé de fabrication d'un composant horloger multicouches, caractérisé en ce qu'il comprend les étapes suivantes:
- Fabriquer au moins une première couche métallique du composant horloger sur la surface supérieure d'un substrat ;
- Séparer le substrat de la structure obtenue par l'étape précédente, pour obtenir une feuille ; puis,
- Réaliser au moins une autre couche métallique du composant horloger et/ou une opération d'usinage d'une couche métallique après séparation du substrat sur la surface supérieure et/ou inférieure de la feuille.

L'invention est plus particulièrement définie par les revendications.

Ces objets, caractéristiques et avantages de la présente invention seront exposés en détail dans la description suivante de modes de réalisation particuliers faits à titre non-limitatif en relation avec les figures jointes parmi lesquelles :
La figure 1 représente une vue en perspective d'un sautoir pour mouvement d'horlogerie.
Les figures 2 à 8 illustrent les étapes successives d'un procédé de fabrication d'un composant métallique qui peuvent être en tout ou partie implémentées dans des modes de réalisation de l'invention.
Les figures 9 à 12 illustrent la mise en oeuvre du procédé de fabrication pour fabriquer un sautoir.
Les figures 13 à 18 illustrent les étapes successives du procédé de fabrication d'un composant métallique selon un mode de réalisation de l'invention.

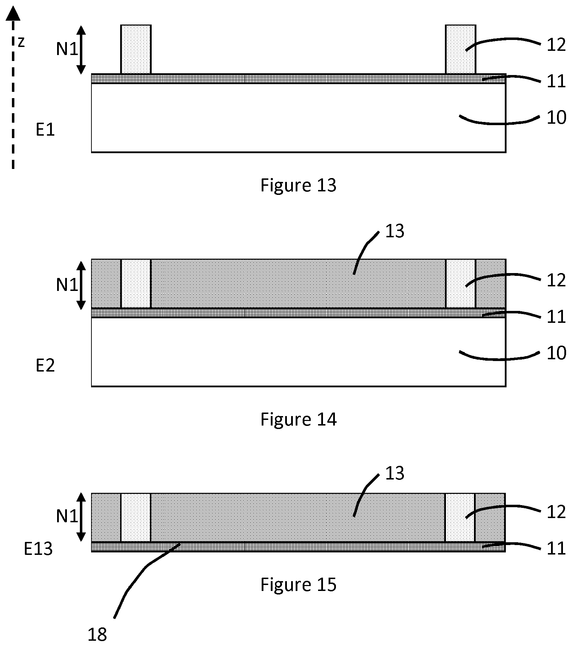

Nous allons décrire un procédé de fabrication d'un composant métallique, en référence avec les figures 13 à 18, particulièrement adapté à la fabrication de microstructures à plusieurs niveaux, notamment pour fabriquer des composants horlogers. Pour une raison de simplification, nous utiliserons les termes « métal » et « métallique » par la suite pour désigner un matériau métallique ou un alliage métallique.

La première étape E1 du procédé de fabrication consiste à fabriquer un premier moule de premier niveau N1 sur un substrat 10. Ce substrat 10 peut être constitué par une plaquette métallique, notamment en alliage comme un acier inoxydable, ou une plaquette de silicium, de verre ou de céramique. Ce substrat est de préférence massif, mais peut également comporter des structures réalisées par microfabrication. Il est préparé selon les règles connues de l'homme de l'art, notamment pour son dégraissage, nettoyage, éventuellement passivation et/ou activation. Ce substrat est avantageusement plan. En variante, il peut comporter des motifs, notamment des motifs usinés, et/ou des cavités, et/ou d'autres structures, selon les enseignements de l'art antérieur. Notamment, il peut comporter des logements pour placer un ou plusieurs inserts destinés à être emprisonnés ou enserrés par les futures couches métalliques déposées pour appartenir finalement au composant métallique, de manière non mobile et non amovible. Dans l'exemple de réalisation illustré, le substrat 10 est dans un matériau conducteur, par exemple en acier inoxydable. En variante, on pourrait aussi utiliser un substrat en un matériau non-conducteur, comme par exemple le silicium.

Optionnellement, une couche conductrice 11 est déposée sur le substrat 10, par exemple par évaporation. Cette couche conductrice 11 est notamment destinée à jouer le rôle de cathode pour l'amorçage d'un dépôt galvanique, ou électrodéposition, ultérieur. De façon connue, cette couche conductrice 11 d'amorçage peut comprendre une sous-couche de chrome, nickel ou de titane recouverte d'une couche d'or ou de cuivre (elle présente ainsi une structure multicouches).

La couche conductrice 11 est recouverte d'une couche initiale de résine photosensible sur une hauteur souhaitée. Cette hauteur est préférentiellement supérieure à 0 et inférieure ou égale à 1.5mm. La résine est une résine photosensible, adaptée à la photolithographie. La résine peut être négative ou positive. Dans le premier cas, elle est conçue pour devenir insoluble ou difficilement soluble à un révélateur sous l'action d'un rayonnement, alors que, dans le second cas, elle est conçue pour devenir soluble à un révélateur sous l'action d'un rayonnement, alors que la partie non exposée au rayonnement reste insoluble ou difficilement soluble. Dans l'exemple particulier de la description, la résine utilisée est de type « SU-8 », qui est une résine photosensible négative qui polymérise sous l'action d'un rayonnement UV, par exemple la résine SU-8-100 de la maison Microchem. Cette couche initiale de résine définit un premier niveau N1.

Une étape de photolithographie de la couche initiale de résine est réalisée, qui consiste à exposer à une radiation lumineuse ou insoler la couche initiale de résine à travers un masque comprenant des ouvertures et des zones opaques. Ce masque définit le motif à reproduire pour la réalisation du premier niveau du composant à fabriquer. Les radiations lumineuses utilisées pour irradier ou insoler la résine sont ici des rayonnements UV émis par une source UV. On pourrait toutefois envisager d'utiliser des rayons X, un faisceau d'électrons (on parle alors de lithographie par faisceau d'électrons) ou tout autre type de radiations selon la résine utilisée. Les rayonnements sont perpendiculaires au plan dans lequel s'étend le masque de manière à n'irradier que les zones de la résine situées au droit des ouvertures ménagées dans le masque. Dans l'exemple de réalisation particulier décrit ici, les zones de résine insolées deviennent insensibles ou insolubles à la plupart des liquides de développement.

L'étape précédente d'exposition à des radiations lumineuses (ou à un faisceau d'électrons) est suivie optionnellement d'une étape de traitement thermique de réticulation, puis d'une étape de développement. Le développement consiste à éliminer les zones de résine non exposées selon un procédé adapté à la résine utilisée, par exemple par dissolution avec un produit chimique ou par un procédé plasma. Après dissolution, la couche conductrice 11 apparaît aux endroits où la résine a été éliminée. Dans le cas d'une résine photosensible positive, les zones insolées seraient éliminées par exemple par voie chimique et les zones non insolées seraient conservées sur le substrat.

Les parties restantes de résine de la couche initiale forment un premier moule 12 en résine de premier niveau N1. Le fond du moule est délimité par la couche conductrice 11. A l'issue de l'étape de développement, on obtient donc le moule et la structure illustrée par la figure 13, dans laquelle un substrat 10 est recouvert d'une couche conductrice 11, sur laquelle un moule 12 en résine a été formé sur un premier niveau N1. Cette construction est réalisée dans une seule direction sensiblement perpendiculaire au substrat 10, que nous appellerons par convention direction verticale z, orientée vers le haut sur les figures de sorte que le moule de premier niveau N1 est considéré formé au-dessus du substrat 10, par convention. Ce substrat 10 plan définit de même par convention un plan horizontal.

Ces étapes de fabrication d'un moule en résine dans un procédé de type LIGA sont connues et ne sont pas illustrées plus en détail.

L'étape suivante E2 du procédé consiste à déposer une première couche métallique 13 dans les cavités du premier moule 12 en résine, par électrodéposition, ou dépôt galvanique. La couche conductrice 11 selon la réalisation illustrée ou en variante le substrat 10 si ce dernier est conducteur, joue le rôle de cathode pour amorcer le dépôt. Cette étape utilise par exemple le procédé LIGA et un métal tel que, par exemple, le nickel (Ni) ou le nickel-phosphore (NiP). La couche métallique 13 obtenue, représentée sur la figure 14, a préférentiellement la même hauteur que celle de la couche initiale de résine, correspondant à la hauteur du moule 12 de résine. Elle peut aussi avoir une hauteur inférieure à la hauteur du moule 12 de résine, ou une hauteur supérieure à la hauteur du moule 12 de résine. De façon optionnelle, cette étape E2 peut comprendre une mise d'épaisseur, par polissage mécanique simultané de la couche métallique et de la résine restante, pour obtenir une surface supérieure parfaitement plane, horizontale. La surface supérieure 15 de la couche métallique est alors parfaitement alignée avec la surface supérieure 16 du moule en résine 12, ces deux surfaces 16, 15 définissant donc le plan supérieur du premier niveau N1 de la structure intermédiaire obtenue après cette formation d'une première couche métallique 13. Ce plan est sensiblement horizontal sur ce mode de réalisation.

En variante de réalisation non représentée, la couche métallique 13 pourrait ne pas occuper toute la hauteur du premier moule 12, sa surface supérieure 15 restant sous la surface supérieure 16 du moule 12.

On procède ensuite au retrait anticipé du substrat 10 du reste de la structure, et optionnellement de l'éventuelle couche conductrice 11.

En pratique, ce retrait peut être mis en oeuvre dès que la première couche métallique est fabriquée, c'est-à-dire après la réalisation de l'étape E2 décrite précédemment, dont le résultat est illustré par la figure 14. Il en résulte une feuille solidaire formée de la première couche métallique 13 et de la résine 12, soit le premier niveau N1 de la structure. Cette feuille remplit finalement la fonction de substrat pour la poursuite du procédé.

Ainsi, à ce stade, le substrat 10 est supprimé ou détaché (en tous cas séparé du reste de la structure), dans une étape E13, pour atteindre la structure représentée sur la figure 15, dénommée feuille.

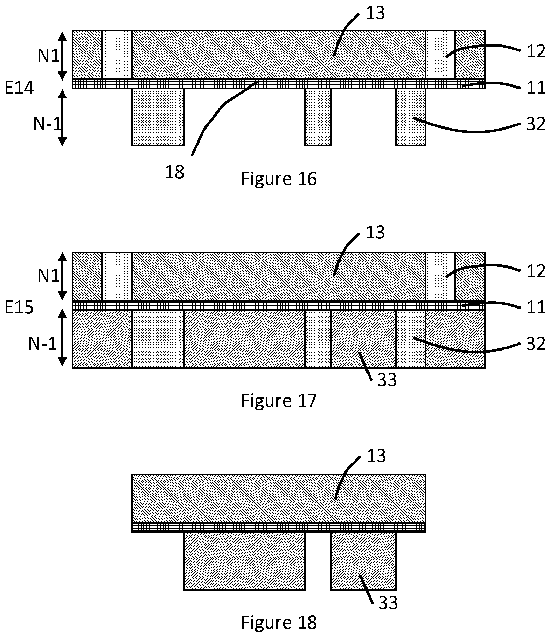

Le procédé comprend ensuite une étape de dépôt d'une deuxième couche de résine, dans cet exemple à nouveau une couche de résine photosensible négative SU-8. En variante, une résine différente peut être utilisée. Dans l'exemple illustré ici, cette deuxième couche est déposée à partir de la surface inférieure 18 de la première couche de niveau N1. Elle définit ainsi un deuxième niveau N-1, s'étendant verticalement au-dessous du premier niveau N1. La hauteur du deuxième niveau N-1 est avantageusement strictement supérieure à 0 et inférieure ou égale à 1,5 mm. Elle peut être égale ou différente de la hauteur du premier niveau, dépendant de la hauteur du second niveau du composant final à fabriquer. L'étape E14 d'obtention d'un deuxième moule 32, comme illustré par la figure 16, est finalisée par photolithographie de la deuxième couche de résine, par des étapes de photolithographie et de développement, analogues à celles des étapes précédemment décrites pour former le moule de résine du premier niveau.

Le procédé comprend ensuite une étape E15 d'électrodéposition ou de dépôt galvanique, consistant à déposer une deuxième couche métallique 33 dans le moule 32. Cette couche s'étend au-dessous de la surface inférieure 18 de la première couche métallique 13. Elle présente de préférence une hauteur d'au moins 10 µm au-dessous de la première couche métallique 13. Elle peut remplir tout ou partie de la hauteur de ce second moule de résine 32 de deuxième niveau N-1. Cette étape peut être suivie de manière optionnelle d'une mise d'épaisseur, par polissage mécanique de la couche métallique et de la résine. Le résultat de cette étape est illustré par la figure 17.

En remarque, l'électrodéposition de la deuxième couche métallique 32 est ici amorcée par la couche conductrice 11 qui recouvrait le substrat 10 et qui a été conservé après retrait du substrat. En variante, cette couche conductrice 11 peut être supprimée en même temps que le substrat 10, l'amorçage étant obtenu par la première couche métallique 13.

Après retrait de la résine, dans une étape E16, un composant métallique à deux niveaux est obtenu, comme illustré par la figure 18.

Cette variante de réalisation permet la mise en oeuvre d'étapes du procédé impossibles à mettre en oeuvre sans le retrait du substrat. Notamment, comme cela a été illustré, elle permet de construire des éléments du composant métallique sous la feuille, plus exactement à partir de la surface inférieure 18 de la première couche métallique 13. Par exemple, une ou plusieurs autres couches métalliques peuvent être ajoutées par croissance à cette couche métallique, par dépôt galvanique ou électrodéposition, par exemple par un procédé LIGA tel que décrit précédemment. Si une couche conductrice 11 a été déposée préalablement au dépôt de la première couche métallique 13, il est possible soit de conserver cette couche conductrice pour les opérations subséquentes, soit de l'éliminer. La feuille sert ainsi de support initial à partir duquel il est possible d'ajouter des couches métalliques sur et sous la première couche métallique 13. Un avantage de l'ajout d'une couche sous cette feuille est de profiter de la planéité de la surface inférieure 18 préalablement construite sur le support 10. Ainsi, pour un composant métallique de trois niveaux à fabriquer, il peut être avantageux de disposer deux couches respectivement sur et sous la feuille pour profiter de la planéité bien maîtrisée des deux surfaces supérieure 15 et inférieure 18 de la feuille.

Comme cela a été évoqué ci-dessus, le procédé de fabrication peut comprendre différentes variantes dans lesquelles d'autres couches du composant sont réalisées au-dessus et/ou au-dessous de la couche métallique 13 supérieure de ce composant métallique. Une fois la feuille (couche métallique et résine juxtaposés) séparée du substrat, toutes les étapes décrites précédemment peuvent être mises en oeuvre sur ce composant. En variante, la résine peut être retirée à un moment ultérieur du procédé.

En remarque, il est en général préférable de déposer une couche conductrice sur l'une des surfaces de la couche métallique, voire sur les deux surfaces. En remarque, l'expression « croissance sous cette couche ou surface » signifie dans le contexte qui précède « sur ou à partir de la surface inférieure de la couche détachée du substrat », la croissance ayant lieu à partir de la surface inférieure 18.

Selon une autre variante de réalisation, le retrait anticipé du substrat pourrait se faire à toute autre étape ultérieure du procédé de fabrication, notamment lorsqu'un composant à plus de deux niveaux est fabriqués, par formation de plus de deux couches. Par exemple, ce retrait pourra être fait juste avant la formation de la dernière couche métallique du composant, et donc avant la dernière étape de dépôt galvanique ou électrodéposition, et éventuellement avant la dernière étape de formation d'un moule en résine. En variante, ce retrait pourrait être fait avant une dernière opération de mise à niveau de la surface supérieure obtenue lors de la dernière étape de dépôt galvanique ou électrodéposition. En variante, ce retrait pourrait être fait avant une dernière opération d'usinage de la surface supérieure obtenue lors de la dernière étape de dépôt galvanique ou électrodéposition.

Pour illustrer ces variantes de réalisation, les figures 2 à 8 illustrent des étapes d'un procédé de fabrication d'un composant multicouches, à plusieurs niveaux, lors duquel le retrait anticipé du substrat 10, non illustré, pourrait être mis en oeuvre à plusieurs étapes du procédé.

Ce procédé de fabrication comprend deux étapes E1, E2, illustrées par les figures 2 et 3, qui correspondent aux figures 13 et 14 et ont déjà été décrites. Comme illustré précédemment, l'étape E13 de retrait du substrat 10 pourrait être mise en oeuvre à ce moment là.

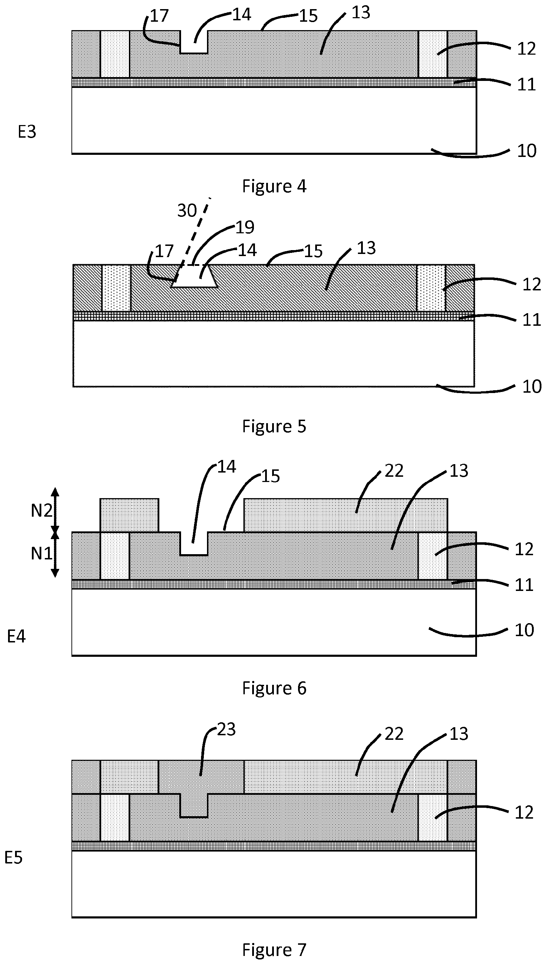

Le procédé comprend ensuite une étape E3 d'usinage de la première couche métallique 13, pour former une cavité 14, illustrée sur la figure 4. Comme cela sera détaillé par la suite, cette cavité a pour fonction de recevoir une partie de la seconde couche métallique qui va être superposée, afin de permettre d'imbriquer les deux couches métalliques.

Cette étape E3 de formation de la cavité 14 comprend une étape d'usinage mécanique, comme un fraisage et/ou un perçage, ou tout autre usinage mécanique. En variante, elle peut être réalisée par ablation laser, par exemple à partir d'un laser à impulsions femtoseconde. En variante, un usinage chimique, ou un usinage par ultrasons, ou un usinage par électroérosion, ou un usinage localisé par décharge dans un milieu diélectrique peut être utilisé.

Cette cavité 14 est formée par une action à partir de la surface supérieure 15 de la couche métallique 13. Dans cet exemple de réalisation, et de façon préférentielle, la cavité 14 finale se présente sous la forme d'un trou borgne. Cette cavité borgne peut présenter différentes profondeurs, pouvant s'étendre jusqu'à 90% au maximum de la hauteur de la couche métallique 13. La cavité peut laisser un minimum de matière au fond de la cavité 14 d'une hauteur supérieure ou égale à 10 µm. Autrement dit, la cavité 14 est séparée du substrat 10 par une épaisseur supérieure ou égale à 10 µm de matière de la première couche métallique 13. La profondeur de la cavité 14 peut être choisie en fonction de la géométrie finale du composant et selon les contraintes mécaniques qu'il va subir, une plus grande profondeur assurant une meilleure imbrication des deux couches superposées et donc une meilleure résistance mécanique finale.

En variante non représentée, une cavité pourrait être traversante (débouchante), cette étape supprimant le métal de la première couche métallique 13 sur toute sa hauteur en une certaine zone, laissant apparaître une partie de la couche conductrice 11 du substrat.

Dans le mode de réalisation illustré par la figure 4, la cavité 14 présente des flancs 17 sensiblement verticaux, et donc sensiblement perpendiculaires à la surface supérieure 15 de la couche métallique 13. En variante, plusieurs cavités, de dimensions, profondeur, et/ou géométrie différentes ou non peuvent être formées.

Selon une variante avantageuse de réalisation, la cavité 14 présente des flancs 17 inclinés, de sorte que la cavité 14 présente une section horizontale plus importante lorsque la profondeur augmente. En variante, les flancs 17 peuvent présenter toute forme non verticale (non totalement perpendiculaire au substrat), de sorte de la cavité 14 comprend une section plane horizontale plus importante à au moins une profondeur sous le niveau de la surface supérieure 15 de la couche métallique 13 que son ouverture 19 au niveau de la surface supérieure 15 de la couche métallique 13. Ces flancs ne sont ainsi pas nécessairement plans. Ils peuvent être courbés. Ils ne sont pas non plus nécessairement continus. Ils peuvent présenter des marches. Dans tous les cas, cette approche améliore encore l'ancrage relatif des deux couches, notamment l'ancrage ou la tenue en direction verticale.

Selon le mode de réalisation illustré par la figure 5, les flancs 17 de la cavité 14 sont inclinés de manière continue de sorte que la section plane de la cavité augmente continument avec sa profondeur sous la surface supérieure 15 de la couche métallique 13. Notamment, la cavité illustrée présente une section selon un plan vertical en forme de queue d'aronde. Cette cavité peut être usinée avec une fraise d'angle ou une fraise pour queue d'aronde, ou par ablation laser avec une incidence oblique du faisceau laser 30.

Le procédé comprend ensuite une étape de dépôt d'une deuxième couche de résine, dans cet exemple à nouveau une couche de résine photosensible négative SU-8. En variante, une résine différente peut être utilisée. Cette deuxième couche est déposée de manière à recouvrir le premier niveau N1. Elle définit ainsi un deuxième niveau N2, s'étendant verticalement au-dessus du premier niveau N1. La hauteur du deuxième niveau N2 est avantageusement strictement supérieure à 0 et inférieure ou égale à 1,5 mm. Elle peut être égale ou différente de la hauteur du premier niveau, dépendant de la hauteur du second niveau du composant final à fabriquer. En remarque, la résine remplit aussi la cavité 14 du premier niveau N1. L'étape E4 d'obtention d'un deuxième moule 22, comme illustré par la figure 6, est finalisée par photolithographie de la deuxième couche de résine, par des étapes de photolithographie et de développement, analogues à celles des étapes précédemment décrites pour former le moule de résine du premier niveau.

Le procédé comprend ensuite une seconde étape E5 d'électrodéposition ou de dépôt galvanique, consistant à déposer une deuxième couche métallique 23 dans le moule 22. Cette couche emplit tout le volume de la cavité 14 puis s'étend au-dessus de la surface supérieure 15 de la première couche métallique 13. Elle présente de préférence une hauteur d'au moins 10 µm au-dessus de la première couche métallique 13, notamment au-dessus de la cavité 14. Elle peut remplir tout ou partie de la hauteur de ce second moule de résine 22 de deuxième niveau N2. La couche métallique 23 comprend ainsi une extension 27 qui occupe la cavité 14.

Cette étape peut être suivie de manière optionnelle d'une mise d'épaisseur, par polissage mécanique de la couche métallique et de la résine. Le résultat de cette étape est illustré par la figure 7.

En remarque, l'électrodéposition de la deuxième couche métallique est ici amorcée par le métal déposé du premier niveau, à la fois par sa surface supérieure 15 et par les surfaces intérieures de la cavité 14 borgne. En variante, elle pourrait être amorcée par la couche conductrice 11 recouvrant le substrat 10 au niveau de la cavité 14 si elle est débouchante.

Ensuite, d'autres couches pourraient être ajoutées. Par exemple, une étape ultérieure réalisée à partir de la figure 7 peut consister en l'étape E13 de retrait du substrat 10, puis en l'ajout d'une couche de niveau N-1 sous la feuille (à deux niveaux N1, N2), de manière similaire à la description en référence avec les figures 15 à 18.

En variante, une autre couche supérieure, de niveau N3, non représentée, pourrait être formée, de manière similaire aux deux précédentes. Le retrait du substrat pourrait être réalisé entre les dépôts des seconde et troisième couches.

Finalement, le procédé met en oeuvre un retrait anticipé du substrat de fabrication du composant, pour laisser une feuille comprenant au moins une couche comprenant des zones juxtaposées de résines et de métal.

Cette séparation anticipée de la feuille du substrat 10 présente les premiers avantages suivants :
- Elle permet toujours la poursuite du procédé de fabrication, comme par exemple la formation d'une cavité borgne (étape E3) dans la couche métallique 13 de la feuille, mais également la réalisation d'un ou plusieurs moules 22 supplémentaires en résine (étape E4), et le dépôt galvanique ou par électrodéposition pour former une nouvelle couche métallique 23 (étape E5), et la répétition de ces étapes pour former des couches superposées supplémentaires, et éventuellement l'insertion d'un objet (insert) ;
- Elle permet aussi toujours des opérations optionnelles de mise à niveau, usinage intermédiaire, ... ;
- La feuille est mince et facile à manipuler pour la mise en oeuvre de ces opérations.

Naturellement, il est aussi possible de procéder à une étape de formation d'une cavité dans la surface inférieure 18 de la première couche métallique 13, pour obtenir une imbrication de la couche métallique 32 formée à partir de cette surface, de manière similaire à la description exposée ci-dessus en référence avec les figures 4 et 5. En remarque, la première couche métallique 13 de la feuille peut ainsi comprendre des cavités 14 à la fois dans sa partie supérieure et dans sa partie inférieure.

Optionnellement, des opérations de reprise ou d'usinage ou de modification de surface, comme le dépôt d'un revêtement, peuvent être effectués sur les composants électrodéposés, que ce soit avant ou après détachage du substrat et/ou avant ou après élimination de la résine.

Les différentes couches métalliques du composant peuvent se présenter dans un même métal, ou en variante dans des matériaux différents.

Le procédé précédemment décrit de fabrication d'un composant métallique peut être utilisé pour la fabrication de composants horlogers tels que, à titre d'exemples illustratifs et non limitatifs, une ancre, un sautoir, une roue, un râteau, un ressort, un balancier, une came, un engrenage ou encore un pont. Il peut naturellement aussi être utilisé pour fabriquer tout élément métallique sous forme de microstructure.

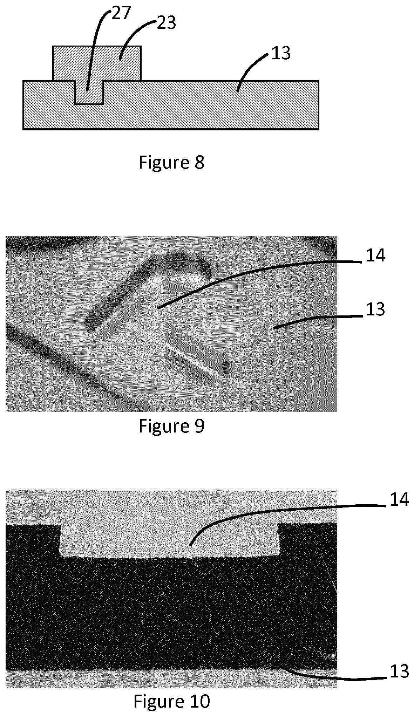

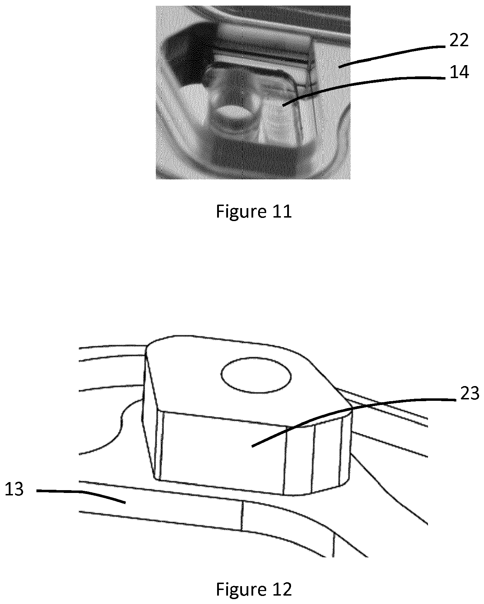

Les figures 9 à 12 illustrent à titre d'exemple la fabrication d'un sautoir à partir des étapes E1 à E5 selon les figures 2 à 8. Les figures 9 et 10 illustrent le résultat obtenu après une étape intermédiaire de réalisation d'une cavité 14 dans une première couche métallique 13. La figure 10 permet notamment de visualiser la forme en queue d'aronde obtenue pour la cavité 14. La figure 11 montre le résultat intermédiaire après formation du moule 22 en résine de second niveau. On distingue la cavité 14 au fond du moule. Le composant est finalisé par croissance d'une seconde couche métallique 23, pour former le second niveau du sautoir, comme illustré sur la figure 12.

Selon une variante du mode de réalisation, le procédé peut comprendre une étape intermédiaire d'ajout d'un insert, avant ou après détachage du substrat, suivie d'une étape de croissance d'une nouvelle couche métallique, qui permet de solidariser l'insert au composant final, et notamment aux deux couches superposées, de l'enserrer. Cet insert peut être en matériau métallique ou conducteur, ou en matériau isolant comme le rubis, le silicium ou la céramique.

En remarque, selon une autre variante de réalisation, la première couche métallique 13 pourrait être réalisée par tout autre procédé, les étapes suivantes E13 à E15 étant conservées.

## Revendications

1. Procédé de fabrication d'un composant horloger multicouches, comprenant l'étape:
- E1, E2 : Fabriquer au moins une première couche métallique (13) du composant horloger sur la surface supérieure d'un substrat (10) ;
**caractérisé en ce qu'**il comprend également les étapes suivantes:
- E13 : Séparer le substrat (10) de la structure obtenue par l'étape précédente, pour obtenir une feuille ; puis,
- E4, E5 ; E14, E15 : Réaliser au moins une autre couche métallique (23 ; 33) du composant horloger et/ou une opération d'usinage d'une couche métallique après séparation du substrat (10) sur la surface supérieure et/ou inférieure de la feuille.

2. Procédé de fabrication d'un composant horloger selon la revendication précédente, **caractérisé en ce que** l'étape de réaliser au moins une autre couche métallique (23 ; 33) du composant horloger après séparation du substrat (10) comprend les étapes suivantes :
- E4 : déposer une résine photosensible sur la surface supérieure (15) de la feuille ;
- E4 : Exposer la résine photosensible à travers un masque et développer la résine pour former un moule (22) ;
- E5 : Déposer un métal ou un alliage galvaniquement dans le moule (22) ;
- Éventuellement répéter les étapes précédentes pour ajouter une ou plusieurs autre(s) couche(s) métallique(s) au-dessus de la structure précédemment formée ; et/ou
- E14 : déposer une résine photosensible sur la surface inférieure (18) de la feuille ;
- E14 : Exposer la résine photosensible à travers un masque et développer la résine pour former un moule (32) ;
- E15 : Déposer un métal ou un alliage galvaniquement dans le moule ;
- Éventuellement répéter les étapes précédentes pour ajouter une ou plusieurs autre(s) couche(s) métallique(s) au-dessous de la structure précédemment formée.

3. Procédé selon l'une des revendications précédentes, **caractérisé en ce qu'**il comprend tout ou partie des étapes complémentaires suivantes réalisées après l'étape de séparation (E13) du substrat (10):
- Usiner la surface d'une nouvelle couche métallique (13, 23, 33) formée par dépôt galvanique, pour augmenter la planéité de la nouvelle couche métallique ;
- Former (E3) au moins une cavité (14) dans une couche métallique, comprenant une étape d'usinage mécanique, comme un fraisage et/ou un perçage, ou une ablation laser, ou un usinage chimique, ou un usinage par ultrasons, ou un usinage par électroérosion, ou un usinage localisé par décharge dans un milieu diélectrique ;
- Déposer une couche conductrice sur une nouvelle couche métallique formée par dépôt galvanique ;
- Disposer un insert dans au moins une couche métallique du composant, de façon à ce que ledit insert soit enserré totalement ou en partie par au moins une couche métallique du composant horloger ;
- Dissoudre la résine formant un ou plusieurs moule(s) (12, 22, 32) de fabrication d'une ou plusieurs couche(s) métallique(s) (13, 23, 33).

4. Procédé de fabrication d'un composant horloger selon l'une des revendications précédentes, **caractérisé en ce qu'**il comprend les étapes suivantes :
- E1 : Déposer une résine photosensible sur la surface du substrat (10) ;
- E1 : Exposer la résine photosensible à travers un masque et développer la résine pour former un moule (12) ;
- E2 : Déposer un métal ou un alliage galvaniquement dans le moule (12) pour former une première couche métallique (13),
- E4, E5 : Eventuellement répéter les étapes précédentes pour former une ou plusieurs autre(s) couche(s) métallique(s) (23) sur la surface supérieure (15) de la première couche métallique (13) ; puis,
- E13 : Séparer le substrat (10) de la structure obtenue pour obtenir une feuille comprenant une ou plusieurs couches, chaque couche comprenant des zones juxtaposées de résines et de métal.

5. Procédé de fabrication d'un composant horloger selon l'une des revendications précédentes, **caractérisé en ce qu'**il comprend les étapes suivantes après séparation du substrat (10) :
- E3 : Former au moins une cavité (14) dans la surface d'une couche métallique (13 ; 23 ; 33);
- E4 : Déposer une résine photosensible sur la surface comprenant la cavité de la couche métallique (13 ; 23 ; 33);
- E4 : Exposer la résine photosensible à travers un masque et développer la résine pour former un moule, libérant au moins une cavité (14) de la surface de la couche métallique (13; 23 ; 33) ;
- E5 : Déposer un métal ou un alliage galvaniquement dans la au moins une cavité (14) et dans ledit moule.

6. Procédé de fabrication d'un composant horloger selon l'une des revendications précédentes, **caractérisé en ce qu'**il est l'un des éléments du groupe comportant un sautoir, une ancre, une roue, une came, un râteau.

## Patentansprüche

1. Verfahren zur Herstellung eines mehrschichtigen Uhrenbauteils, umfassend den Schritt:
- E1, E2: Herstellen mindestens einer ersten metallischen Schicht (13) des Uhrenbauteils auf der Oberseite eines Substrats (10);
**dadurch gekennzeichnet, dass**
es außerdem die folgenden Schritte umfasst:
- E13: Trennen des Substrats (10) von der im vorangegangenen Schritt erhaltenen Struktur, um ein Blatt zu erhalten; sodann
- E4, E5; E14, E15: Erstellen mindestens einer weiteren metallischen Schicht (23; 33) des Uhrenbauteils und/oder ein Bearbeitungsschritt einer metallischen Schicht nach Abtrennen des Substrats (10) auf der Ober- und/oder Unterseite des Blattes.

2. Verfahren zur Herstellung eines Uhrenbauteils gemäß dem vorangehenden Anspruch, **dadurch gekennzeichnet, dass** der Schritt zum Erstellen mindestens einer weiteren metallischen Schicht (23; 33) des Uhrenbauteils nach Abtrennen des Substrats (10) die folgenden Schritte umfasst:
- E4: Aufbringen eines lichtempfindlichen Harzes auf die Oberseite (15) des Blattes;
- E4: Belichten des lichtempfindlichen Harzes durch eine Maske hindurch und Entwickeln des Harzes, um eine Form (22) zu bilden;
- E5: Galvanisches Einbringen eines Metalls oder einer Legierung in die Form (22);
- Gegebenenfalls Wiederholen der vorangehenden Schritte, um eine oder mehrere weitere Schicht(en) auf die vorangehend gebildete Struktur aufzubringen; und/oder
- E14: Aufbringen eines lichtempfindlichen Harzes auf die Unterseite (18) des Blattes;
- E14: Belichten des lichtempfindlichen Harzes durch eine Maske hindurch und Entwickeln des Harzes, um eine Form (32) zu bilden;
- E15: Galvanisches Einbringen eines Metalls oder einer Legierung in die Form;
- Gegebenenfalls Wiederholen der vorangehenden Schritte, um eine oder mehrere weitere Schicht(en) unterhalb der vorangehend gebildeten Struktur aufzubringen.

3. Verfahren gemäß einem der vorangehenden Ansprüche, **dadurch gekennzeichnet, dass** es alle oder Teile der folgenden zusätzlichen Schritte umfasst, die nach dem Schritt (E13) des Abtrennens des Substrats (10) erfolgen:
- Bearbeiten der Oberfläche einer neuen, durch galvanisches Abscheiden gebildeten metallischen Schicht (13, 23, 33) zur Verbesserung der Ebenheit der neuen metallischen Schicht;
- Bilden (E3) mindestens einer Vertiefung (14) in einer metallischen Schicht, umfassend einen mechanischen Bearbeitungsschritt, wie Fräsen und/oder Bohren, oder eine Laserablation, oder eine chemische Bearbeitung, oder eine Bearbeitung mittels Ultraschall, oder eine Bearbeitung mittels Elektroerosion, oder eine Bearbeitung, die durch Entladung in einem dielektrischen Milieu lokalisiert wird;
- Aufbringen einer leitenden Schicht auf eine neue, durch galvanisches Abscheiden gebildete metallische Schicht;
- Einbringen eines Einsatzes in mindestens eine metallische Schicht des Bauteils, derart, dass der genannte Einsatz vollständig oder teilweise von mindestens einer metallischen Schicht des Uhrenbauteils eingeschlossen ist;
- Auflösen des eine oder mehrere Herstellungsform(en) (12, 22, 32) für eine oder mehrere metallischen Schicht(en) (13, 23, 33) bildenden Harzes.

4. Verfahren zur Herstellung eines Uhrenbauteils gemäß einem der vorangehenden Ansprüche, **dadurch gekennzeichnet, dass** es die folgenden Schritte umfasst:
- E1: Aufbringen eines lichtempfindlichen Harzes auf die Oberfläche des Substrats (10);
- E1: Belichten des lichtempfindlichen Harzes durch eine Maske hindurch und Entwickeln des Harzes zur Bildung einer Form (12);
- E2: Galvanisches Einbringen eines Metalls oder einer Legierung in die Form (12) zur Bildung einer ersten metallischen Schicht (13),
- E4, E5: Gegebenenfalls Wiederholen der vorangehenden Schritte zur Bildung einer oder mehrerer weiterer metallischen Schicht(en) (23) auf der Oberseite (15) der ersten metallischen Schicht (13); sodann,
- E13: Abtrennen des Substrats (10) von der erhaltenen Struktur, um ein Blatt mit einer oder mehreren Schicht(en) zu erhalten, wobei jede Schicht nebeneinander liegende Bereiche aus Harz und aus Metall umfasst.

5. Verfahren zur Herstellung eines Uhrenbauteils gemäß einem der vorangehenden Ansprüche, **dadurch gekennzeichnet, dass** es die folgenden Schritte nach Abtrennen des Substrats (10) umfasst:
- E3: Bilden mindestens einer Vertiefung (14) in der Oberfläche einer metallischen Schicht (13; 23; 33);
- E4: Aufbringen eines lichtempfindlichen Harzes auf die Oberfläche, die die Vertiefung in der metallischen Schicht (13; 23; 33) umfasst;
- E4: Belichten des lichtempfindlichen Harzes durch eine Maske hindurch, Entwickeln des Harzes zur Bildung einer Form, Freisetzen mindestens einer Vertiefung (14) auf der Oberfläche der metallischen Schicht (13; 23; 33);
- E5: Galvanisches Einbringen eines Metalls oder einer Legierung in die mindestens eine Vertiefung (14) und in die genannte Form.

6. Verfahren zur Herstellung eines Uhrenbauteils gemäß einem der vorangehenden Ansprüche, **dadurch gekennzeichnet, dass** es eines der Bauteile der Gruppe ist, umfassend eine Hebelfeder, ein Anker, ein Rad, eine Kurvenscheibe, ein Rechen.

## Claims

1. A process for manufacturing a multilayer timepiece component, comprising the step:
- E1, E2: manufacturing at least one first metal layer (13) of the timepiece component on the upper surface of a substrate (10);
**characterized in that** it also comprises :
- E13: separating the substrate (10) from the structure obtained by the preceding step, in order to obtain a sheet; then
- E4, E5; E14, E15: producing at least one other metal layer (23; 33) of the timepiece component and/or carrying out an operation for machining a metal layer after separation of the substrate (10) on the upper and/or lower surface of the sheet.

2. The process for manufacturing a timepiece component as claimed in the preceding claim, **characterized in that** the step of producing at least one other metal layer (23; 33) of the timepiece component after separation of the substrate (10) comprises the following steps:
- E4: depositing a photoresist on the upper surface (15) of the sheet;
- E4: exposing the photoresist through a mask and developing the resist in order to form a mold (22);
- E5: depositing a metal or an alloy galvanically in the mold (22);
- optionally repeating the preceding steps in order to add one or more other metal layer (s) on top of the structure previously formed; and/or
- E14: depositing a photoresist on the lower surface (18) of the sheet;
- E14: exposing the photoresist through a mask and developing the resist in order to form a mold (32);
- E15: depositing a metal or an alloy galvanically in the mold;
- optionally repeating the preceding steps in order to add one or more other metal layer(s) underneath the structure previously formed.

3. The process as claimed in either of the preceding claims, **characterized in that** it comprises all or some of the following additional steps carried out after the step of separation (E13) of the substrate (10):
- machining the surface of a new metal layer (13, 23, 33) formed by galvanic deposition, in order to increase the flatness of the new metal layer;
- forming (E3) at least one cavity (14) in a metal layer, comprising a step of mechanical machining, such as a milling and/or a drilling, or a laser ablation, or a chemical machining, or an ultrasound machining, or an electrical discharge machining, or a localized machining by discharge in a dielectric medium;
- depositing a conductive layer on a new metal layer formed by galvanic deposition;
- positioning an insert in at least one metal layer of the component, so that said insert is completely or partly buried by at least one metal layer of the timepiece component;
- dissolving the resist forming one or more mold(s) (12, 22, 32) for manufacturing one or more metal layer (s) (13, 23, 33) .

4. The process for manufacturing a timepiece component as claimed in one of the preceding claims, **characterized in that** it comprises the following steps:
- E1: depositing a photoresist on the surface of the substrate (10);
- E1: exposing the photoresist through a mask and developing the resist in order to form a mold (12);
- E2: depositing a metal or an alloy galvanically in the mold (12) in order to form a first metal layer (13);
- E4, E5: optionally repeating the preceding steps in order to form one or more other metal layer (s) (23) on the upper surface (15) of the first metal layer (13); then
- E13: separating the substrate (10) from the structure obtained in order to obtain a sheet comprising one or more layers, each layer comprising juxtaposed resist and metal regions.

5. The process for manufacturing a timepiece component as claimed in one of the preceding claims, **characterized in that** it comprises the following steps after separation of the substrate (10):
- E3: forming at least one cavity (14) in the surface of a metal layer (13; 23; 33);
- E4: depositing a photoresist on the surface comprising the cavity of the metal layer (13; 23; 33);
- E4: exposing the photoresist through a mask and developing the resist in order to form a mold, freeing up at least one cavity (14) of the surface of the metal layer (13; 23; 33);
- E5: depositing a metal or an alloy galvanically in the at least one cavity (14) and in said mold.

6. The process for manufacturing a timepiece component as claimed in one of the preceding claims, **characterized in that** it is one of the elements of the group comprising a jumper, a pallet, a wheel, a cam, a rack.
